# EUROPEAN PATENT APPLICATION

(11) **EP 4 300 607 A1**
(43) Date of publication of application: **03.01.2024**
(21) Application number: 22760105.1
(22) Date of filing: 25.02.2022
(51) Int. Cl.: H01L 33/62, F21K 9/20, F21Y 115/10

(54) **LIGHT-EMITTING ELEMENT PACKAGE AND LIGHTING DEVICE HAVING SAME**

(30) Priority: 26.02.2021 KR 20210026136
(71) Applicant: LG Innotek Co., Ltd., Seoul 07796 (KR)
(72) Inventor: CHOI, Young Jae, Seoul 07796 (KR); PARK, Moo Ryong, Seoul 07796 (KR)
(74) Representative: Plasseraud IP
(86) International application number: PCT/KR2022/002771
(87) International publication number: WO 2022/182189

(57) **Abstract**

The lighting device disclosed in the embodiment of the invention includes a light emitting device package including a plurality of lead frames, a body coupled to the plurality of lead frames, a cavity in which a front side portion of the body is opened, and a light emitting chip disposed on a first lead frame that is any one of the plurality of lead frames; a circuit board on which the light emitting device package is disposed and having a first pad portion; a resin layer covering the light emitting device package on the circuit board; a reflective member disposed between the resin layer and the circuit board and into which a lower portion of the light emitting device package is inserted; and a light blocking portion overlapping the light emitting device package in a vertical direction on the resin layer, wherein the first lead frame may include a first frame disposed at a bottom of the cavity and is bent from the first frame to a lower surface of the body, and a first bonding portion coupled to the first pad portion of the circuit board, and the first bonding portion may protrude from the lower surface of the body toward a rear side portion of the body more than the rear side portion of the body.

## Description

### [Technical Field]

An embodiment of the invention relates to a light emitting device package and a lighting device having the same.

### [Background Art]

The light emitting device package may be, for example, a device having a light emitting diode, and the light emitting diode is a semiconductor device that converts electrical energy into light, and is in the limelight as a next-generation light source replacing fluorescent lamps and incandescent lamps. Since the light emitting diode generates light using a semiconductor device, it consumes very low power compared to an incandescent lamp that generates light by heating tungsten or a fluorescent lamp that generates light by colliding ultraviolet rays generated through high-voltage discharge with a phosphor. Since the light emitting diode generates light using a semiconductor device, it has a longer lifespan, faster response characteristics, and eco-friendly characteristics than conventional light sources. In addition, light emitting diodes are used in lighting devices such as various lamps used indoors or outdoors, liquid crystal display devices, electric signboards, vehicle lighting, or street lights.

### [Disclosure]

### [Technical Problem]

An embodiment of the invention provides a side-view type light emitting device package having a large area of a lead frame on which a light emitting chip is disposed, and a lighting device having the same. An embodiment of the invention provides a light emitting device package in which a plurality of light emitting chips is disposed on a first lead frame and a bonding portion of the first lead frame is extended to a lower surface of the body than the width of the body, and a lighting device having the same.

An embodiment of the invention provides a light emitting device package in which each of the plurality of light emitting chips is electrically connected to second and third lead frames. An embodiment of the invention provides a light emitting device package in which at least one bonding portion disposed on the lower surface of the light emitting device package protrudes more than the front surface of the body and a lighting device having the same.

### [Technical Solution]

A lighting device according to embodiment of the invention includes a light emitting device package including a plurality of lead frames, a body coupled to the plurality of lead frames, a cavity in which a front side portion of the body is opened, and a light emitting chip disposed on a first lead frame that is any one of the plurality of lead frames; a circuit board on which the light emitting device package is disposed and having a first pad portion; a resin layer covering the light emitting device package on the circuit board; a reflective member disposed between the resin layer and the circuit board and into which a lower portion of the light emitting device package is inserted; and a light blocking portion overlapping the light emitting device package in a vertical direction on the resin layer, wherein the first lead frame may include a first frame disposed at a bottom of the cavity and is bent from the first frame to a lower surface of the body, and a first bonding portion coupled to the first pad portion of the circuit board, and the first bonding portion may protrude from the lower surface of the body toward a rear side portion of the body more than the rear side portion of the body.

The lighting device disclosed in the embodiment of the invention includes a light emitting device package including a plurality of lead frames, a body coupled to the plurality of lead frames, a cavity in which a front side portion of the body is opened, and a light emitting chip disposed on a first lead frame that is any one of the plurality of lead frames; a circuit board on which the light emitting device package is disposed and having a first pad portion; a resin layer covering the light emitting device package on the circuit board; a reflective member disposed between the resin layer and the circuit board and into which a lower portion of the light emitting device package is inserted; and a light blocking portion overlapping the light emitting device package in a vertical direction on the resin layer, wherein the first lead frame may include a first frame disposed at a bottom of the cavity and is bent from the first frame to a lower surface of the body, and a first bonding portion coupled to the first pad portion of the circuit board, and the first bonding portion may protrude from the lower surface of the body toward a front side portion of the body more than the front side portion of the body.

According to an embodiment of the invention, the plurality of lead frames includes second and third lead frames disposed on both sides of the first lead frame, and a plurality of light emitting chips may be disposed on the first frame of the first lead frame. According to an embodiment of the invention, the first bonding portion may have a width from the bottom of the cavity toward the rear side portion greater than a length, and a length direction of the first bonding portion may be perpendicular to a width direction and may be in a direction from the third side portion to the fourth side portion of the body. According to an embodiment of the invention, a ratio of the length to the width of the first bonding portion may be in a range of 1:6 to 1:8.

According to an embodiment of the invention, the length of the first bonding portion from the bottom of the cavity toward the front side portion is greater than the depth of the cavity, and an end of the first bonding portion may not contact an imaginary straight line passing through an inner surface of the cavity adjacent to the first bonding portion. According to an embodiment of the invention, a horizontal imaginary straight line passing through the first bonding portion of the light emitting device package may be inclined at an angle of 7 degrees to 12 degrees with respect to an upper surface of the circuit board. According to an embodiment of the invention, an imaginary straight line passing through an exit surface of the cavity disposed on the front side portion of the light emitting device package may be inclined at an angle of 91 degrees to 100 degrees with respect to the upper surface of the circuit board.

According to an embodiment of the invention, the lighting device includes at least one diffusion layer on the resin layer; and a light transmitting layer made of an adhesive material on a lower surface of the at least one diffusion layer, the light blocking portion may be disposed on a lower surface of the at least one diffusion layer. According to an embodiment of the invention, the light blocking portion may include a plurality of pattern layers having different sizes, and the uppermost layer of the plurality of pattern layers may have the largest area and the lowermost layer may have the smallest area.

According to an embodiment of the invention, the reflective member may include an opening through which the first pad portion to which the first bonding portion of the light emitting device package is bonded is exposed, and the reflective member may include a reflective pattern on a surface thereof.

### [Advantageous Effects]

An embodiment of the invention may improve heat dissipation efficiency and light efficiency of light emitting chips in a light emitting device package. An embodiment of the invention may reduce light loss and lower hot spots by obliquely mounting a light emitting device package on a substrate.

An embodiment of the invention may improve the luminous flux of a light emitting device package and a lighting device having the same, thereby providing optical reliability.

### [Description of Drawings]

FIG. 1 is a plan view showing a light emitting device package according to a first embodiment of the invention.
FIG. 2 is an A-A cross-sectional view of the light emitting device package of FIG. 1.
FIG. 3 is a B-B cross-sectional view of the light emitting device package of FIG. 1.
FIG. 4 is a bottom view of the light emitting device package of FIG. 1 viewed from a first side portion.
FIG. 5 is an example of a lighting module in which the light emitting device package of FIG. 1 is disposed on a substrate.
FIG. 6 is an example of a cross-sectional side view of the lighting module of FIG. 5.
FIG. 7 is a view illustrating openings and pads of the reflective member on the substrates of FIGS. 5 and 6.
FIG. 8 is an example of a lighting device in which light emitting device packages according to the first embodiment are arranged.
FIG. 9 is a C-C side cross-sectional view of the lighting device of FIG. 8.
FIG. 10 is a side cross-sectional view of a light emitting device package according to a second embodiment, and is a modified example of FIG. 2.
FIG. 11 is an example of a bottom view of the light emitting device package of FIG. 10.
FIG. 12 is a side cross-sectional view of a lighting module having a light emitting device package of FIG. 10.
FIGS. 13 and 14 are examples of lighting devices having a light emitting device package of a comparative example, and are diagrams comparing light paths.
FIG. 15 is a lighting device having a light emitting device package according to a second embodiment, and is a view comparing light paths with those of FIGS. 13 and 14.
FIG. 16 is an example of a light blocking member in a lighting device according to an embodiment of the invention.
FIG. 17 is another example of a lighting device to which a light emitting device package according to an embodiment of the invention is applied.

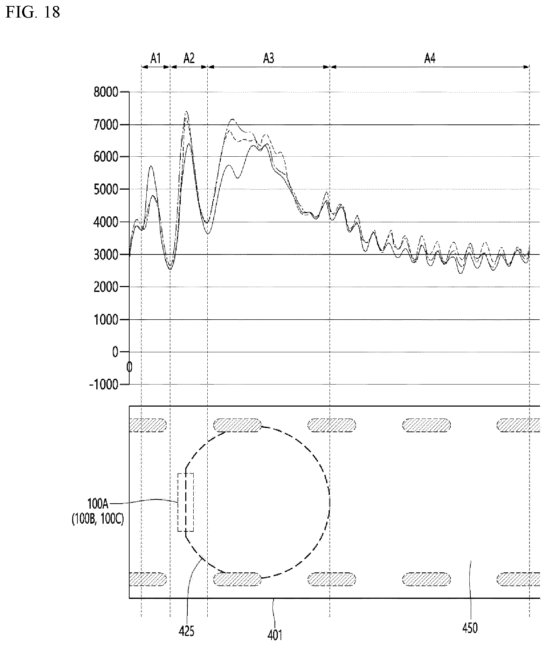

FIG. 18 is a diagram illustrating light distribution in a lighting device having a light emitting device package according to a second embodiment.
FIG. 19 is a diagram showing a temperature characteristic graph of samples of the light emitting device package according to the first embodiment.
FIG. 20 is a plan view of a vehicle to which a lamp having a lighting device or a lighting module according to an embodiment of the invention is applied.
FIG. 21 is a diagram illustrating a lamp having the lighting module or lighting device of FIG. 20.

### [Best Mode]

Hereinafter, a preferred embodiment in which a person skilled in the art can easily practice the invention will be described in detail with reference to the accompanying drawings. However, it should be understood that the embodiments described in this specification and the configurations shown in the drawings are only one preferred embodiment of the invention, and there may be various equivalents and modifications that may replace them at the time of this application. In describing the operating principle of the preferred embodiment of the invention in detail, if it is determined that a detailed description of a related known function or configuration may unnecessarily obscure the subject matter of the invention, the detailed description will be omitted. Terms to be described later are terms defined in consideration of functions in the invention, and the meaning of each term should be interpreted based on the contents throughout this specification. The same reference numerals are used throughout the drawings for parts having similar functions and actions. Since the embodiments and the configurations illustrated in the drawings are preferred embodiments of the invention and do not represent all of the technical ideas of the invention, there may be various equivalents and modifications that may replace them at the time of the present application. Hereinafter, embodiments will be clearly revealed through the accompanying drawings and description of the embodiments. In the description of the embodiments, when each layer (film), area, pattern, or structure is described as being formed on or under the substrate, each layer (film), region, pad, or pattern, "on" and "under" include both "directly" or "directly" through other layers. In addition, the criterion for the top or bottom of each layer will be described based on the drawings. Throughout this specification, "frontward" or "front" and "rearward" or "rear" refer to the direction in which the package is viewed from the Y direction, and "left side" and "right side" refer to the direction in which the package is viewed from the X direction, The upward direction and the downward direction may be directions in which the package is viewed from the Z direction.

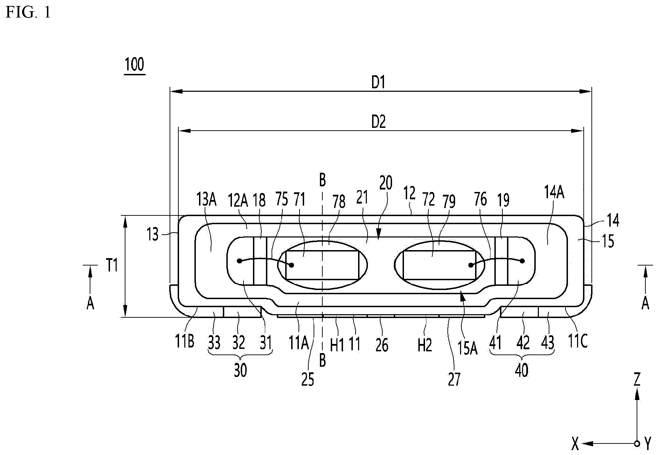

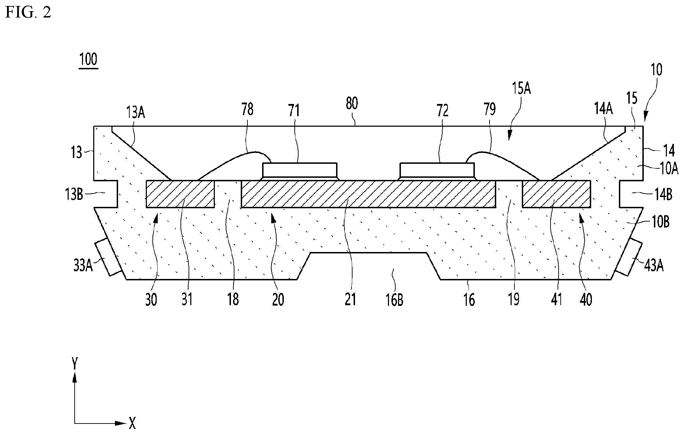

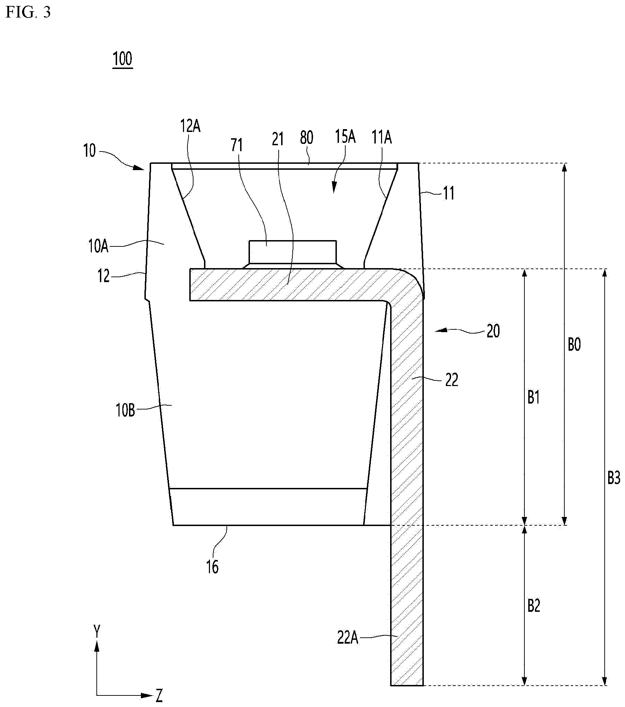

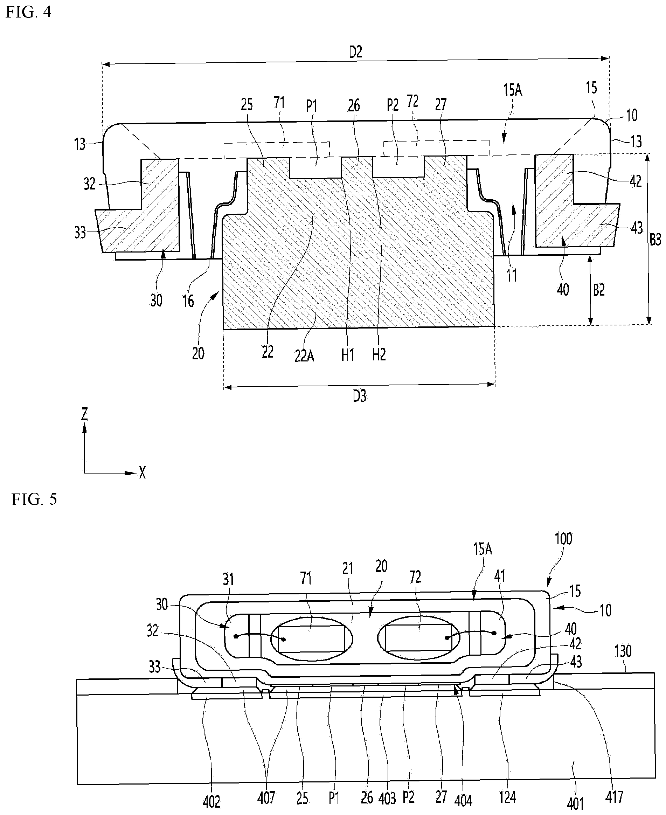

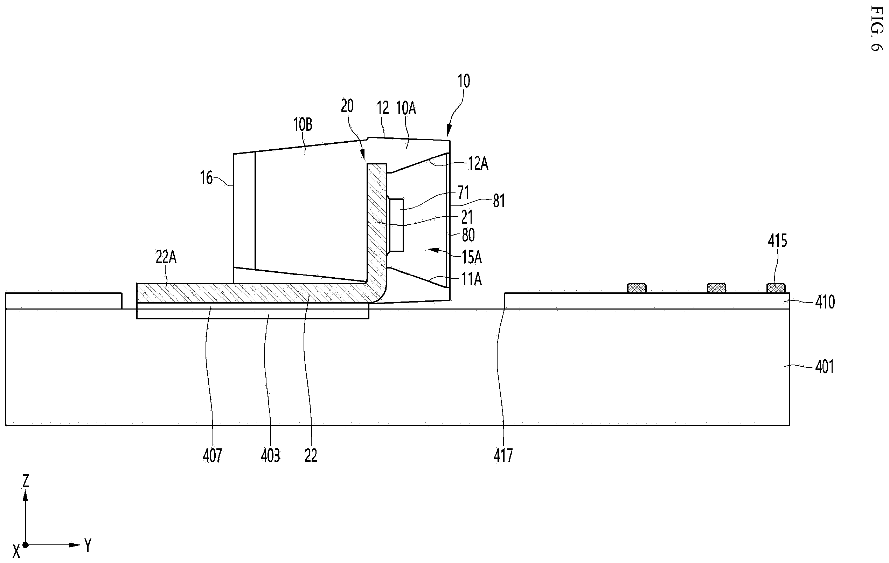

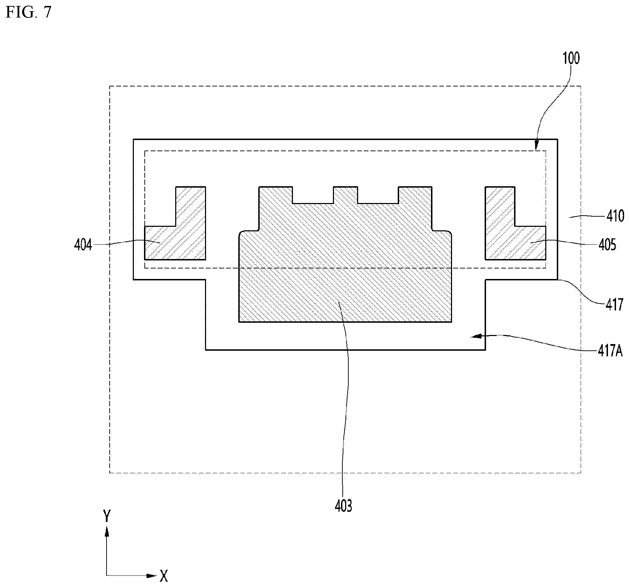

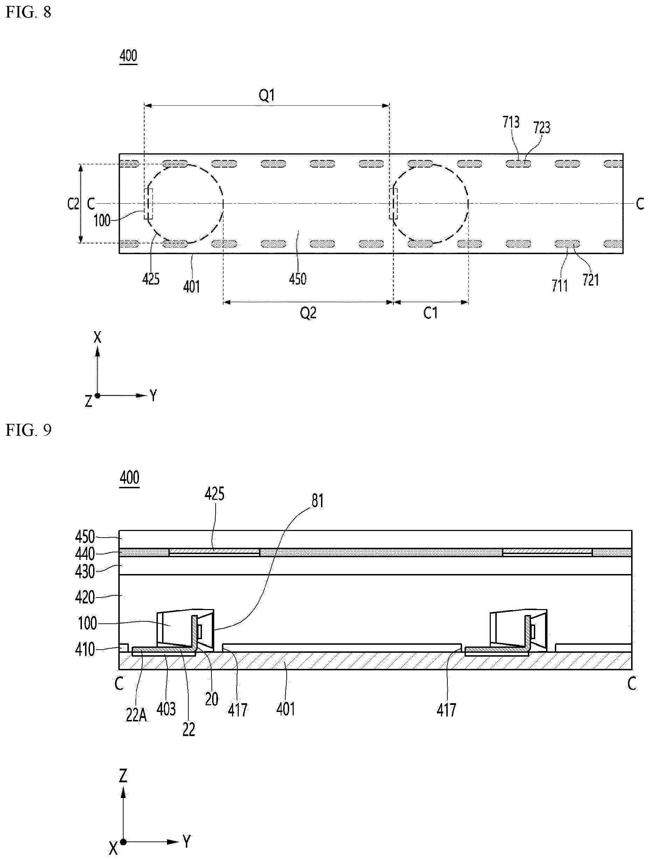

Hereinafter, a light emitting device package according to an embodiment of the invention will be described with reference to the accompanying drawings. FIG. 1 is a plan view showing a light emitting device package according to a first embodiment of the invention, FIG. 2 is an A-A cross-sectional view of the light emitting device package of FIG. 1, FIG. 3 is a B-B side cross-sectional view of the light emitting device package of FIG. 1, FIG. 4 is a bottom view of the light emitting device package of FIG. 1 viewed from a first side surface, FIG. 5 is an example of a lighting module in which the light emitting device package of FIG. 1 is disposed on a substrate, FIG. 6 is a side cross-sectional view of the lighting module of FIG. 5, FIG. 7 is a view illustrating openings and pads of the reflective member on the substrates of FIGS. 5 and 6, FIG. 8 is an example of a lighting device in which light emitting device packages are arranged according to the first embodiment, and FIG. 9 is a C-C side sectional view of the lighting device of FIG. 8.

Referring to FIGS. 1 to 9, the light emitting device package 100 includes a body 10 having a cavity 15A, a plurality of lead frames 20, 30, and 40 disposed in the cavity 15A, and a plurality of light emitting chips 71 and 72 disposed on at least one of the plurality of lead frames 20, 30, and 40. The light emitting device package 100 may be implemented as a side view type package and may emit at least one of red, green, blue, or white light. The lighting module having the light emitting device package 100 may include one or a plurality of light emitting device packages 100 arranged on a circuit board 401, and may be applied to mobile phones, portable computers, various types of lighting fields, vehicle lamps, or pointing devices. For convenience of description, the first direction may be the X direction or the length direction of the package, the second direction may be the Y direction or the width direction of the package, and the third direction may be the Z direction or the thickness direction of the package.

Referring to FIGS. 1 to 4, the light emitting device package 100 is a package having a long length in the first direction X, for example, the length D1 in the first direction X may be 3 times or more, for example, 3 times to 4.5 times greater than the thickness T1 of the third direction Z. The length D2 of the body 10 in the first direction X may be three or more times larger than the respective lengths in the second and third directions Y and Z. The length D2 of the body 10 in the first direction may be 4 mm or more, for example, in the range of 4 mm to 7 mm or in the range of 4.5 mm to 6.5 mm. Since the body 10 provides a long length D2 in the first direction X, the exit side area or light emitting area of the cavity 15A may be increased in the first direction X. In addition, since the light emitting area of the cavity 15A is large, each of the light emitting chips 71 and 72 may have a long length in the first direction X. For example, each of the light emitting chips 71 and 72 may have a length in the first direction X twice or more, for example, a range of 2 to 3 times the width in the second direction Y.

The thickness T1 of the light emitting device package 100 may be equal to or greater than the thickness of the body 10. The thickness of the body 10 may be 1/3 times or less than the length D2 of the body 10 in the first direction X, thereby providing a package having a small thickness. The maximum length D 1 of the light emitting device package 100 in the first direction X may be equal to or greater than the length D2 of the body 10. Here, the maximum length D1 of the first direction X may be 4 mm or more, for example, in the range of 4 mm to 8 mm or in the range of 4 mm to 6.5 mm. The maximum length D1 of the light emitting device package 100 may increase or decrease in proportion to the length D2 of the body 10. Since the length D1 of the light emitting device package 100 in the first direction is long, when the light emitting chips 71 and 72 are arranged in the first direction X, the number or length of the light emitting chips 71 and 72 may increase. The thickness T1 of the light emitting device package 100 may be 1.5 mm or less, for example, in the range of 0.6 mm to 1.5 mm. Since the thickness T1 of the light emitting device package 100 may be provided relatively thin, the thickness of a lighting module or lamp having the light emitting device package 100 may be reduced.

The body 10 may be coupled with a plurality of lead frames 20, 30, and 40. The body 10 may be formed of an insulating material. The body 10 may be formed of a reflective material. The body 10 may be formed of a material having a reflectance higher than transmittance, for example, a reflectance of 70% or more with respect to wavelengths emitted from the light emitting chips 71 and 72. The body 10 may be formed of a resin material such as polyphthalamide (PPA) or epoxy. The body 10 may be formed of a silicone-based, epoxy-based, or thermosetting resin including a plastic material, or a material with high heat resistance and high light resistance. The body 10 includes a white-based resin. The body 10 may include at least one of an acid anhydride, an antioxidant, a release agent, a light reflector, an inorganic filler, a curing catalyst, a light stabilizer, a lubricant, and titanium dioxide.

The body 10 may include a reflective material, for example, a resin material to which metal oxide is added, and may effectively reflect incident light. As another example, the body 10 may be formed of a light-transmissive resin material or a resin material having a phosphor that converts the wavelength of incident light.

The side surfaces of the body 10 may include a first side portion 11 which is a lower surface, the second side portion 12 on the opposite side of the first side portion 11, and third and fourth side portions 13 and 14 adjacent to each of the first side portion 11 and the second side portion 12 and disposed on opposite sides of each other. The first and second side portions 11 and 12 may be both side surfaces in the third direction Z, and the third and fourth side portions 13 and 14 may be both side surfaces in the first direction X. The first side portion 11 is a lower surface of the body 10, the second side portion 12 may be an upper surface of the body 10, and the first and second side portions 11 and 12 is a long side surface having a length D2 of the body 10, and the third and fourth side portions 13 and 14 may be short side surfaces having a thickness smaller than the thickness T1 of the body 10. The first side portion 11 of the body 10 may be a surface corresponding to the circuit board 401. The length D2 of the first direction X of the body 10 is a distance between the third and fourth side portions 13 and 14, and may be three times greater than a distance between the first and second side portions 11 and 12.

In the body 10, the front side portion 15 is a surface on which the cavity 15A is disposed, and may be a surface from which light is emitted. The rear side portion 16 on the opposite side of the front side portion 15 may be the rear side of the first side portion 11 and the second side portion 12.

The body 10 may include a first body 10A in which the cavity 15A is disposed and a second body 10B at a rear side of the first body 10A. The first body 10A may be disposed in front of the lead frames 20, 30, and 40 and disposed around the cavity 15A. The second body 10B may support the lead frames 20, 30, and 40 and support a package. The first body 10A may be an upper body or a front body, and the second body 10B may be a lower body or a rear body. The first and second bodies 10A and 10B may be integrally formed or formed separately from each other and then bonded to each other.

The cavity 15A may include first to fourth inner surfaces 11A, 12A, 13A, and 14A. The first inner surface 11A may be a surface adjacent to the first side surface portion 11, and the second inner surface 12A may be a surface adjacent to the second side surface portion 12. The first and second inner surfaces 11A and 12A may face each other and may be inclined or curved with respect to the bottom of the cavity 15A. The third inner surface 13A may be a surface adjacent to the third side surface portion 13, and the fourth inner surface 14A may be a surface adjacent to the fourth side surface portion 14. The third and fourth inner surfaces 13A and 14A may face each other and may be inclined or curved with respect to the bottom of the cavity 15A. An inclination angle of an imaginary straight line connecting both ends of the third and fourth inner surfaces 13A and 14A may be smaller than an inclination angle of an imaginary straight line connecting both ends of the first and second inner surfaces 11A and 12A, respectively. Accordingly, the cavity 15A may provide a wide light beam angle distribution in the first direction X rather than in the third direction Z.

The depth B7 of the cavity 15A is a distance from the front side portion 15 of the body 10 to the bottom of the cavity 15A, and is less than 1/3 of the length of the body 10 in the second direction Y. For example, it may be in the range of 0.3 mm ± 0.05 mm. When the depth B7 of the cavity 15A is less than the above range, it is difficult to control the light spread angle, and when the depth B7 of the cavity 15A exceeds the above range, the length of the body 10 in the second direction Y increases or the light spread angle narrows.

A portion of each of the plurality of lead frames 20, 30, and 40 may be disposed on the bottom of the cavity 15A, and another portion may protrude toward at least one side portion of the body 10. For example, another portions of the plurality of lead frames 20, 30, and 40 may protrude from the first side portion 11. The plurality of lead frames 20, 30, and 40 may include a first lead frame 20 and second and third lead frames 30 and 40 disposed on both sides of the first lead frame 20. The first lead frame 20 may be disposed between the second and third lead frames 30 and 40. Each of the lead frames 20, 30, and 40 may have a thickness of 2 mm or less, for example, in the range of 1.5 mm to 2 mm. When it is smaller than the above range, heat dissipation efficiency or thermal conduction efficiency may be reduced, and when it is larger than the above range, a thickness of the package may be increased.

The first lead frame 20 may include a first frame 21 disposed at a center of the bottom of the cavity 15A and a first bonding portion 22 protruding from the first frame 21 to the first side portion 11. The second lead frame 30 may include a second frame 31 disposed on one side of the bottom of the cavity 15A and a second bonding portion 32 protruding from the second frame 31 to one side of the first side portion 11. The third lead frame 40 may include a third frame 41 disposed on the other side of the bottom of the cavity 15A and a third bonding portion 42 protruding from the third frame 41 to the other side of the first side portion 11.

The plurality of light emitting chips 71 and 72 may be disposed on the first frame 21 of the first lead frame 20 and electrically connected to the second and third frames 31 and 41. Among the plurality of light emitting chips 71 and 72, the first light emitting chip 71 may be connected to the first frame 21 through a bonding member 78 and connected to the second frame 31 through a wire 75. The second light emitting chip 72 may be connected to the first frame 21 through a bonding member 79 and connected to the third frame 41 through a wire 76. As another example, when the light emitting chips 71 and 72 are flip chips, the first light emitting chip 71 may be bonded to the first and second frames 21 and 31 in a flip manner, and the second light emitting chip 72 may be bonded to the first and third frames 21 and 4 in a flip manner.

The first frame 21 is disposed between the second frame 31 and the third frame 41 and may contact the first inner surface 11A and the second inner surface 12A. The second frame 31 is disposed between the first frame 21 and the third side surface portion 13 and may contact the first to third inner surfaces 11A, 12A, and 13A. The third frame 41 is disposed between the first frame 21 and the fourth side surface portion 14 and may contact the first, second, and fourth inner surfaces 11A, 12A, and 14A. Separating portions 18 and 19 may be disposed between the first frame 21 and the second frame 31 and between the first frame 21 and the third frame 41, respectively. The separating portions 18 and 19 may be arranged parallel to each other or in an oblique shape. The first bonding portion 22 may protrude from the first side portion 11 of the body 10 and be bent toward the rear side portion 16. Here, a region between the first frame 21 and the first bonding portion 22 may include a plurality of coupling holes H1 and H2 disposed between a plurality of connecting potions 25 and 26 and disposed between a plurality of connecting portions 26 and 27.

The plurality of connection portions 25, 26, and 27 may be disposed from the second bonding portion 32 toward the third bonding portion 42. The plurality of coupling holes H1 and H2 are respectively disposed between the plurality of connection parts 25, 26, and 27, and portions of the body 10 may protrude through the coupling holes H1 and H2. Here, heat generated from the first frame 21 on which the first and second light emitting chips 71 and 72 are disposed may be dissipated through different paths in the connection portions 25, 26, and 27 without mutual interference. The number of the connection portions 25, 26, and 27 may be two or three or more.

The second bonding portion 32 of the second lead frame 30 is disposed on one side of the first side surface portion 11 of the body 10, that is, may be disposed on one side of the bottom surface of the second body 10B. The third bonding portion 42 is disposed on the other side of the first side surface portion 11 of the body 10, that is, may be disposed on the other side of the bottom surface of the second body 10B. The second bonding portion 32 includes a first extension portion 33 to increase a heat dissipation area, and the first extension portion 33 extends from a part of the second bonding portion 32 toward the third side portion 13 of the body 10, and a part 33A of the first extension portion 33 may be bent to face the third side surface portion 13. The part 33A of the first extension portion 33 may come into close contact with the third side surface part 13. The third bonding portion 42 includes a second extension portion 43 to increase a heat dissipation area, and the second extension portion 43 extends from a portion of the third bonding portion 42 toward the fourth side portion 14 of the body 10, and a part 43A of the second extension portion 43 may be in close contact with the fourth side portion 14. A heat dissipation area may be increased by the first and second extension portions 33 and 43. As shown in FIG. 1, in the thickness of the body 10, a thickness of a region adjacent to the third and fourth side portions 13 and 14 may be smaller than a thickness of the center region of the body 10. This means that the first side portion 11 of the body 10 has concave regions 11B and 11C adjacent to the third and fourth side portions 13 and 14, and the second and third bonding portions 32 and 42 of the third lead frames 30 and 40 may be disposed in the second and second concave regions 11B and 11C.

The light emitting chips 71 and 72 may have a vertical chip structure. The light emitting chips 71 and 72 may selectively emit light within a wavelength range of ultraviolet to visible light. The light emitting chips 71 and 72 may be selected from, for example, red LED chips, blue LED chips, green LED chips, and yellow green LED chips. The light emitting chips 71 and 72 may emit, for example, a red peak wavelength. The light emitting chips 71 and 72 may include at least one of a group II-VI compound and a group III-V compound. The light emitting chips 71 and 72 may be formed of, for example, a compound selected from the group consisting of GaN, AlGaN, InGaN, AlInGaN, GaP, AlN, GaAs, AlGaAs, InP, and mixtures thereof. Thermal stress of the light emitting chips 71 and 72 may be adjusted according to the heat dissipation area of the first lead frame 20. For example, when thermal stress increases, light drop within the package increases, and when thermal stress decreases, light drop within the package decreases.

As shown in FIG. 2, the third and fourth side portions 13 and 14 of the body 10 may have concave portions 13B and 14B recessed inwardly, and fingers supporting the body 10 may be inserted into the concave portions 13B and 14B during the ejection process of the body 10. The concave portions 13B and 14B may be disposed on an extension line in which the second and third frames 31 and 41 of the first and third lead frames 30 and 40 extend horizontally. The concave portions 13B and 14B may be spaced apart from the second and third frames 31 and 41. The depth of the concave portions 13B and 14B may have a depth at which a partial region of the concave portions 13B and 14B overlaps the cavity 15A, for example, a portion of the cavity 15A in a vertical direction.

A molding member 80 is disposed in the cavity 15A of the body 10, and the molding member 80 includes a light transmitting resin such as silicon or epoxy and may be formed in a single layer or multiple layers. When the light emitting chips 71 and 72 are red LED chips, impurities such as phosphors may not be included in the molding member 80. As another example, a phosphor for changing a wavelength of light emitted may be included on the molding member 80 or the light emitting chips 71 and 72, and the phosphor may include light emitted from the light emitting chips 71 and 72. A portion of the light is excited and emitted as light of a different wavelength. The phosphor may be selectively formed from quantum dots, YAG, TAG, silicate, nitride, and oxy-nitride-based materials. The phosphor may include at least one of a red phosphor, a yellow phosphor, and a green phosphor, but is not limited thereto. The surface of the molding member 80 may be formed in a flat shape, a concave shape, a convex shape, etc., but is not limited thereto. As another example, a light-transmissive film having a phosphor may be disposed on the cavity 15A, but is not limited thereto.

A lens may be further formed on the upper portion of the body 10, and the lens may include a structure of a concave lens or/and a convex lens, and may control light distribution of light emitted from the light emitting device package 100. Semiconductor device such as a light receiving device and a protection device may be mounted on the body 10 or any one of the lead frames, and the protection device may be implemented as a thyristor, a Zener diode, or a transient voltage suppression (TVS), and the Zener diode protects the light emitting chips 71 and 72 from ESD (electro static discharge). The plurality of light emitting chips 71 and 72 may be connected in parallel or individually driven by the first to third lead frames 20, 30, and 40.

According to an embodiment of the invention, the total area of the first lead frame 20 on which the light emitting chips 71 and 72 are disposed may be increased. For example, the area of the first bonding portion 22 of the first lead frame 20 may be increased. An area of the lower surface of the first bonding portion 22 may be twice or more larger than the sum of the areas of the lower surface of the second bonding portion 32 and the third bonding portion 42. The area of the lower surface of the first bonding portion 22 may be four times larger than an area of the lower surface of the second bonding portion 32 or the third bonding portion 42.

As shown in FIGS. 3 and 4, in the first embodiment of the invention, the first bonding portion 22 of the first lead frame 20 may include a heat dissipating portion 22A protruding further backward than the rear portion 16 of the body 10. In the second direction Y, a width B3 of the first bonding portion 22 may be greater than a width B0 of the body. The width B3 of the first bonding portion 22 may be 1.1 times or more, for example, in the range of 1.1 times to 1.5 times the width B0 of the body 10. In the first direction X, the length D3 of the first bonding portion 22 may be 50% or more of the length D2 of the body, for example, in the range of 50% to 60%. The length D3 of the first bonding portion 22 may be 2.8 mm or more, for example, in the range of 2.8 mm to 3.5 mm. When the area of the first bonding portion 22 is smaller than the above range, there is a limit to reducing thermal stress generated by the plurality of light emitting chips 71 and 72, and when it is larger than the above range, there is a problem that the package area is increased compared to stress reduction. The length D3 of the first bonding portion 22 may be smaller than the width B3 of the first bonding portion 22. Here, the width direction may be a direction orthogonal to the length direction. The ratio (D3:B3) of the length and width of the first bonding portion 22 may be in the range of 1:6 to 1:8, and the width B3 of the first bonding portion 22 increases in the rear direction, and thus, the heat dissipation area may be increased.

Here, the width B2 of the heat dissipating portion 22A may protrude more than 7 mm in the rear direction from the rear side portion 16 of the body 10, for example, in a range of 7 mm to 12 mm. In the width B3 of the first bonding portion 22, this is when the width from the bottom of the cavity 15A to the rear side portion 16 of the body 10 is B1 and the width of the heat dissipating portion 22A is B2, the ratio of B1:B2 may range from 1:0.7 to 1:1. The width B2 of the heat dissipating portion 22A may be greater than or equal to 7 mm, for example, in the range of 7 mm to 12 mm. The first bonding portion 22 having the heat dissipating portion 22A may dissipate stably conducted heat or conduct through the circuit board 401, thereby lowering thermal stress generated by the light emitting chips 71 and 72 and preventing a decrease in light speed.

Referring to FIGS. 4 to 7, the lighting module includes a circuit board 401 and at least one or a plurality of light emitting device packages 100 disposed on the circuit board 401. The circuit board 401 includes a board on which a circuit pattern is printed on an insulating layer, and for example, a resin-based printed circuit board (PCB), a metal core PCB, a flexible PCB, ceramic PCB, or FR-4 substrate. The circuit board 401 includes a metal core PCB, and the metal core PCB further includes a metal layer having better heat dissipation efficiency than other resin-based substrates. For example, a metal core PCB includes a multilayer structure having a metal layer, an insulating layer on the metal layer, and a wiring layer on the insulating layer, and the metal layer is made of a metal having good thermal conductivity to a thickness of 0.3 mm or more, thereby increasing heat dissipation efficiency.

In the light emitting device package 100, the bonding portions 22, 32, and 42 of the first to third lead frames 20, 30, and 40 may be electrically connected to the pad portions 404, 403, and 405 of the circuit board 401, and, for example, it may be bonded with an adhesive member 407. The adhesive member 407 may include solder or conductive tape. In this case, the light exit surface of the light emitting device package 100 may be in a direction orthogonal to the upper surface of the circuit board 401.

A reflective member 410 is disposed on the circuit board 401 to prevent overflow of solder and to protect patterns of the pad portions 404, 403, and 405, and to reflect the light emitted from the light emitting device package 100. The reflective member 410 may be a solder resist material or a separate reflective film. The reflective member 410 may include a dot-shaped reflective pattern 415 on an upper surface. The pattern interval of the dot-shaped reflective pattern 415 may be narrower in a region adjacent to the exit side of the light emitting device package 100 and narrower as a region is farther from the exit side of the light emitting device package 100.

Referring to FIGS. 4 and 7, the pad portions 403, 404, and 405 may be exposed through the opening 417 of the reflective member 410. In the pad portions 403, 404, and 405, the first pad portion 403 may have the same shape as the first bonding portion 22, and may be disposed within a range of 100% to 120% of the area of the first bonding portion 22. The second pad portion 404 may have the same shape as the second bonding portion 32 and may face each other, and the third pad portion 405 may have the same shape as the third bonding portion 42 and may face each other. Here, the area of the upper surface of the first pad portion 403 may be twice or more than the sum of the areas of the second and third pad portions 404 and 405. The first pad portion 403 may further protrude in a rear direction based on the region of the light emitting device package 100.

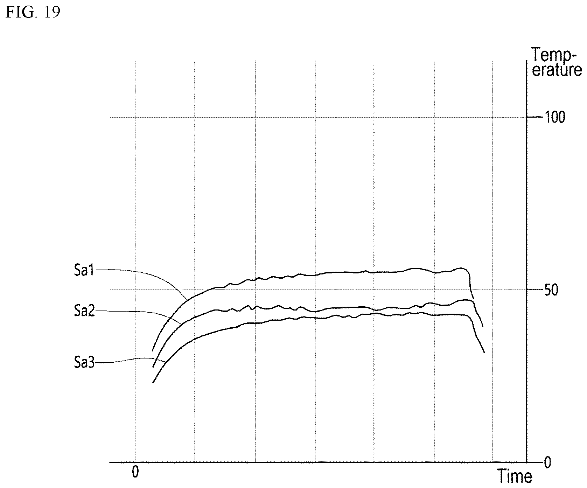

As shown in FIGS. 6 and 7, the opening 417 of the reflective member 410 may be provided with a size into which the lower portion of the light emitting device package 100 may be inserted. The opening 417 may include a region 417A that is further opened in the rear direction of the first pad portion 403, and a protruding portion of the first pad portion 403 is disposed through the region 417A and may be bonded to the first bonding portion 22 and the adhesive member 407 on the first pad portion 403. As shown in FIGS. 19 and 6, when the samples Sa1, Sa2, and Sa3 of the light emitting device package 100 disclosed above are driven on the circuit board 401, the junction temperature between the pad portion 403 and the second bonding portion 22 starts at ambient temperature (25 degrees) in the chamber of 85 degrees and gradually increase, and it may be seen that the maximum is lower than 54 degrees. Due to the increase in the heat dissipation area, the junction temperature may be lowered by 2 degrees or more compared to other packages without the heat dissipating portion 22A, and thermal stress of the light emitting chips 71 and 72 may be suppressed.

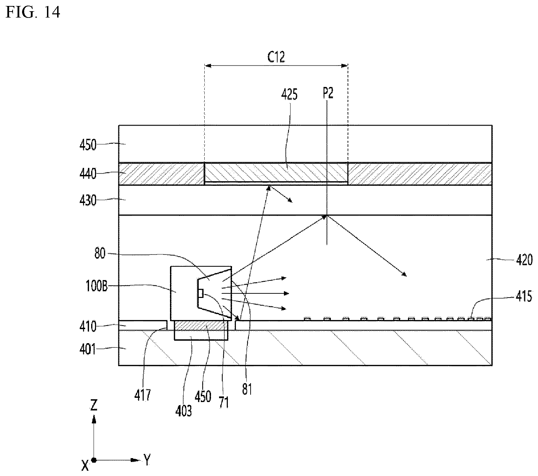

In the light emitting device package 100 according to the first embodiment, since the large-area first bonding portion 22 and the second and third bonding portions 32 and 42 on both sides of the first bonding portion 22 may bonded with the first, second, and third pad portions 403, 404, and 405 of the circuit board 401 and the adhesive member 407, the light emitting device package 100 of FIG. 14 may be disposed on the circuit board 401 without tilting. That is, since the bonding area of the first bonding portion 22 is increased, not only the heat dissipation efficiency is increased, but also the tilt problem in which the height of the front side portion 15 of the light emitting device package 100 is lowered may be eliminated. Since the light emitting device package 100 is disposed not to be tilted, a hot spot generated by light bouncing from the lower surface of the front end of the light emitting device package 100 may be removed.

FIG. 8 is a plan view illustrating a lighting device having a light emitting device package according to a first embodiment of the invention, and FIG. 9 is a C-C side cross-sectional view of the lighting device of FIG. 8.

Referring to FIGS. 8 and 9, the lighting device 400 may include a circuit board 401, a plurality of light emitting device packages 100 disposed on the circuit board 401, and a resin layer 420 covering the plurality of light emitting device packages 100 disposed on the circuit board 401, and at least one diffusion layer 430 or 450 on the resin layer 420. The lighting device 400 may emit light emitted from the light emitting device package 100 as a surface light source.

The circuit board 401 may be electrically connected to the light emitting device package 100. The circuit board 401 includes a wiring layer (not shown) having a pad portion thereon, and the wiring layer may be electrically connected to each of the light emitting device packages 100. The light emitting device package 100 may be disposed on, for example, the circuit board 401 and electrically connected to the pad portions 403, 404, and 405(see FIG. 7) of the circuit board 401 by a conductive adhesive member 407. When the plurality of light emitting device packages 100 are arranged on the circuit board 401, the plurality of light emitting device packages 100 may be connected in series, parallel, or series-parallel by the wiring layer. The circuit board 401 may function as a base member or a support member disposed under the light emitting device package 100 and the resin layer 420. The circuit board 401 may include a light transmitting material through which light is transmitted through upper and lower surfaces. The light transmitting material may include at least one of polyethylene terephthalate (PET), polystyrene (PS), and polyimide (PI).

The light emitting device package 100 is disposed on the circuit board 401 and emits light in a forward direction or a second direction Y. The light emitting device package 100 emits light having the highest intensity in the second direction Y in a horizontal direction. The light emitting device package 100 may have an exit surface 81 through which light is emitted, and the exit surface 81 may be a surface of the molding member 80 described above. For example, the exit surface 81 may be disposed in the third direction Z or in the vertical direction with respect to the horizontal upper surface of the circuit board 401. The exit surface 81 may be a vertical plane or may include a concave surface or a convex surface.

The light emitting device package 100 may be disposed as a first light emitting device package from one end of the circuit board 401 and a second light emitting device package in an emission direction of the first light emitting device package. The first light emitting device package and the second light emitting device package irradiate light in the direction of the other end of the circuit board 401 or in the second direction Y. That is, the first light emitting device package emits light in the same direction as the second light emitting device package, and the second light emitting device package emits light in the direction of the other end of the circuit board 401 or in the opposite direction where the first light emitting device package is disposed. As another example, the light emitting device packages 100 may be dispersively arranged in different directions or in different positions rather than in the same direction.

The reflective member 410 may be disposed between the circuit board 401 and the resin layer 420 and adhered to an upper surface of the circuit board 401. The reflective member 410 may have an area smaller than the area of the upper surface of the circuit board 401. The reflective member 410 may be spaced apart from the edge of the circuit board 401, and the resin layer 420 may be attached to the circuit board 401 in the spaced region. In this case, peeling of the edge portion of the reflective member 410 may be prevented. Here, the reflective member 410 may be removed when a highly reflective material is coated on the upper surface of the circuit board 401.

The reflective member 410 may be formed to have a thickness smaller than that of the light emitting device package 100. The thickness of the reflective member 410 may include a range of 0.2 mm ± 0.02 mm. A lower portion of the light emitting device package 100 may pass through the opening 417 of the reflective member 410 and an upper portion of the light emitting device package 100 may protrude.

The reflective member 410 may include a metallic material or a non-metallic material. The metallic material may include a metal such as aluminum, silver, or gold. The non-metallic material may include a plastic material or a resin material. The plastic material may be any one selected from the group consist of polyethylene, polypropylene, polystyrene, polyvinyl chloride, polybiphenyl chloride, polyethylene terephthalate, polyvinyl alcohol, polycarbonate, polybutylene terephthalate, polyethylene naphthalate, polyamide, polyacetal, polyphenylene ether, polyamideimide, polyetherimide, polyetheretherketone, polyimide, polytetrafluoroethylene, liquid crystal polymer, fluororesin, copolymers thereof, and mixtures thereof. As the resin material, a reflective material such as TiO₂, Al₂O₃, or SiO₂ may be added to silicon or epoxy. The reflective member 410 may be implemented as a single layer or multiple layers, and light reflection efficiency may be improved by such a layer structure. The reflective member 410 according to an embodiment of the invention may increase the amount of light so that light is uniformly distributed by reflecting incident light.

The reflective member 410 may include a plurality of open regions 711 and 713 at an edge side. The plurality of open regions 711 and 713 include a plurality of first and second open regions 711 and 713 spaced apart along the edge of the circuit board 401, and the first and second open regions 711 and 713 have an elliptical shape, circular or polygonal shape. Since each of the first and second open regions 711 and 713 of the reflective member 410 is long in one direction, deterioration in adhesive strength of the region adjacent to the long side edge of the circuit board 401 may be prevented. The resin layer 420 may be disposed on the first and second open regions 711 and 713 and the reflective member 410. The resin layer 420 may be adhered to the upper surface of the circuit board 401 through the first and second open regions 711 and 713 to fix the outer portion of the reflective member 410.

The resin layer 420 may be disposed on the circuit board 401. The resin layer 420 may face the circuit board 401. The resin layer 420 may be disposed on the entire upper surface or a partial region of the circuit board 401. An area of the lower surface of the resin layer 420 may be equal to or smaller than an area of the upper surface of the circuit board 401. The resin layer 420 may be formed of a transparent material. The resin layer 420 may include a resin material such as silicone or epoxy.

Since the resin layer 420 is provided as a layer for guiding light with resin, it may be provided with a thinner thickness than glass and may be provided as a flexible plate. The resin layer 420 may emit a point light source emitted from the light emitting device package 100 in the form of a line light source or a planar light source. Since the resin layer 420 is disposed on the light emitting device package 100, the light emitting device package 100 may be protected and loss of light emitted from the light emitting device package 100 may be reduced. The light emitting device package 100 may be buried under the resin layer 420.

The resin layer 420 may contact the surface of the light emitting device package 100 and may contact the exit surface 81 of the light emitting device package 100. A portion of the resin layer 420 may be disposed in the opening 417 of the reflective member 410. A portion of the resin layer 420 may contact the upper surface of the circuit board 401 through the opening 417 of the reflective member 410. Accordingly, as a part of the resin layer 420 comes into contact with the circuit board 401, the reflective member 410 may be fixed between the resin layer 420 and the circuit board 401.

Each side surface of the resin layer 420 may be disposed on the same plane as each side surface of the circuit board 401. The resin layer 420 may have a thickness of 1.8 mm or more, for example, in the range of 1.8 to 2.5 mm. when the thickness of the resin layer 420 is thicker than the above range, the luminous intensity may decrease, and it may be difficult to provide a flexible module due to the increase in module thickness. When the thickness of the resin layer 420 is smaller than the above range, it is difficult to provide a surface light source with uniform light intensity. The resin layer 420 may be provided in a size to cover the plurality of light emitting device packages 100 or may be connected to each other. The resin layer 420 may be separated into a size that covers each light emitting device package 100, and may be divided into each light emitting device package 100/each light emitting cell having each resin layer 420.

The at least one diffusion layer 430 or 450 may be disposed as a single layer or a plurality of layers, and the single-layer diffusion layer may be adhered to the upper surface of the resin layer 420, or in the case of a plurality of layers, a first diffusion layer 430 may be attached to the upper surface of resin layer 420 with an adhesive and an upper second diffusion layer 450 may be attached to the first diffusion layer 430 by the light transmitting layer 440. Here, the light blocking portion 425 may be disposed between the resin layer 420 and at least one diffusion layer 430 or 450. Here, when the plurality of diffusion layers 430 and 450 are disposed, it may be divided into a lower first diffusion layer 430 adjacent to the resin layer 430 and an upper second diffusion layer 450 thereon. For example, the light transmitting layer 440 may be disposed between the resin layer 420 and the first diffusion layer 430 or between the first and second diffusion layers 430 and 450. An upper surface of the resin layer 420 may have a first adhesive force. The upper surface of the resin layer 420 may have a first adhesive force and be adhered to the first diffusion layer 430.

The light transmitting layer 440 may attach the second diffusion layer 430 on the first diffusion layer 430. The light transmitting layer 440 may include an adhesive material such as silicon or epoxy, or a diffusion material. The diffusion material may include at least one of polyester (PET), poly methyl methacrylate (PMMA), or poly carbonate (PC). The light transmitting layer 440 may include an adhesive region that is bonded to the upper surface of the resin layer 420 or the upper surface of the first diffusion layer 430, and a non-adhesive region that is not adhered to or separated from the upper surface of the resin layer 420 or the first diffusion layer 430. The light transmitting layer 440 occupies 60% or more, for example, 80% or more and 95% or less of the upper surface area of the resin layer 420, so that the second diffusion layer 450 may be in close contact with the resin layer 420 or the first diffusion layer 430.

The light blocking portion 425 may be provided in a size or area sufficient to prevent hot spots caused by light emitted in an exit direction of the light emitting device package 100 on each light emitting device package 100. In addition, since the light emitting device package 100 emits light in the side direction, that is, in the second direction Y, the light blocking portion 425 covers the region where the light blocking efficiency may be increased due to the light beam angle distribution and light reflection characteristics of the light emitting device package 100. The light blocking portion 425 may face the upper surface of the circuit board 401. The light blocking portion 425 may overlap the light emitting device package 100 in the vertical direction Z. Each of the plurality of light blocking portions 425 may overlap each of the plurality of light emitting device packages 100 in the vertical direction.

The distance Q2 between the light blocking portions 425 may be smaller than the distance Q1 between the light emitting device packages 100. The light blocking portion 425 may be spaced apart from a side surface of the resin layer 420. A plurality of light blocking portions 425 may be arranged in the second direction Y. The plurality of light blocking portions 425 may have the same shape as each other. The light blocking portion 425 may be divided into a first light blocking portion on the first light emitting device package and a second light blocking portion on the second light emitting device package. The first and second light blocking portions may be disposed above each of the first and second light emitting elements in an emission direction.

The light blocking portion 425 may be disposed higher than the upper surface of the resin layer 420. The light blocking portion 425 may be disposed between the upper surface of the resin layer 420 and the second diffusion layer 430, and may be an air gap, a reflective material, or an absorbing material.

The light blocking portion 425 may be disposed within the light transmitting layer 440. The light blocking portion 425 may pass through the light transmitting layer 440 and may contact at least one of the resin layer 420 or the first and second diffusion layers 430 and 450. The light blocking portion 425 may include a gap spaced apart from an inner surface of the light transmitting layer 440 or/and an upper surface of the resin layer 420. The gap may provide a refractive index different from the refractive index of the light blocking portion 425, thereby improving light diffusion efficiency.

The light blocking portion 425 may have an area on the light emitting device package 100 that is one or more times larger than the area of the upper surface of the light emitting device package 100 or in a range of 1 to 10 times. The light blocking portion 425 may be a region printed with a white material. The light blocking portion 425 may be printed using a reflective ink containing any one of, for example, TiO₂, Al₂O₃, CaCO₃, BaSO₄, and Silicon. The light blocking portion 425 reflects light emitted through the light emitting surface of the light emitting device package 100 to reduce occurrence of hot spots on the light emitting device package 100.

The light blocking portion 425 may print a light blocking pattern using light blocking ink. The light blocking portion 425 may be formed, for example, by being printed on the lower surface of the second diffusion layer 450. Here, when the diffusion layer is disposed as a single layer, the light blocking portion 425 may be formed on the upper or lower surface of the first diffusion layer 430.

The light blocking portion 425 is a material that does not block 100% of incident light, and may have transmittance lower than reflectance, and may perform functions of blocking and diffusing light. The light blocking portion 425 may be formed in a single layer or multiple layers, and may have the same pattern shape or different pattern shapes. The light blocking portion 425 may have the same thickness. The light blocking portion 425 may have a different thickness according to regions. The thickness of the light blocking portion 425 may be the thickest in the center region and thinner in the edge region than the center region. The light blocking portion 425 may be thick in proportion to the incident light intensity.

Since the size of the light blocking portion 425 is larger than the area of the upper surface of the light emitting device package 100, the problem in which the light emitting device package 100 is visible from the outside may be reduced and the hot spot on the region of the light emitting device package 100 may be reduced, so that a uniform light distribution may be provided over the entire region.

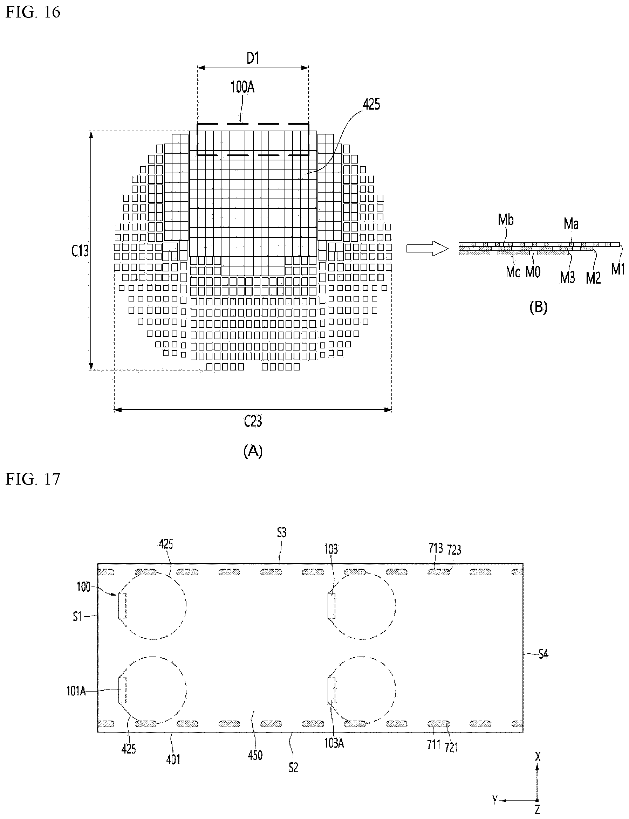

As shown in FIG. 16, the light blocking portion 425 has a length C23 and a width C13, and may be stacked with a plurality of pattern layers M1, M2, and M3, from the top to the bottom, the first pattern layer M1, the second pattern layer M2, and the third pattern layer M3 may be sequentially stacked. The area of the second pattern layer M2 may be smaller than that of the first pattern layer M1, and the area of the third pattern layer M3 or the lowermost pattern layer may be smaller than that of the second pattern layer M2. The first to third pattern layers M1, M2, and M3 may be overlapped on the light emitting device 100, respectively, and may have a gradually smaller layer number or gradually thin thickness in a direction toward an exit side or in a region far from the light emitting device 100. The first to third pattern layers M1, M2, and M3 have different patterns and/or areas, and may overlap each other in a vertical direction. The reflective patterns Ma of the first pattern layer M1 have a smaller size than the reflective patterns Mb of the second pattern layer M2, and may be arranged at a pitch smaller than the pitch that of the reflective patterns Mb of the second pattern layer M2. The reflective patterns Mb of the second pattern layer M2 have a smaller size than the reflective patterns Mc of the third pattern layer M3, and may be arranged at a pitch smaller than the pitch that of the reflective patterns Mc of the third pattern layer M3.

Here, the area of the first pattern layer M1 disposed on the uppermost side of the light blocking portion 415 may be the widest, and the area of the third pattern layer M3 may be the smallest. One ends of the first, second, and third pattern layers M1, M3, and M3 may be arranged on the same line, and the other ends may be arranged stepwise at different heights. An adhesive material M0 such as silicon or epoxy may be filled in the reflective patterns Ma, Mb, and Mc of the first to third pattern layers M1, M2, and M3. Since the light blocking portions 425 are stacked as pattern layers M1, M2, and M3 having multi-layered reflective patterns Ma, Mb, and Mc on the light emitting device 100, it is an effect of blocking light incident to the light blocking portion 425. Also, since the region of the light blocking portion 425 adjacent to the light emitting device 100 is thickest and the farther away from it is provided with a thinner thickness, light uniformity may be improved through a difference in light intensity according to a difference in distance.

The thickness of the light blocking portion 425 may be 0.1 times or less, for example, 0.05 to 0.1 times the thickness of the resin layer 420. The light blocking portion 425 may have a thickness of 100 µm or more, for example, in a range of 100 µm to 200 µm. When the thickness of the light blocking portion 425 is less than the above range, there is a limit to reducing hot spots, and when it is greater than the above range, light uniformity may be degraded. The distance between the upper surface of the light emitting device 100 and the lower surface of the light blocking portion 425 may be 1 mm or more, for example, in the range of 1 mm to 2 mm. The region of the light blocking portion 425 may not overlap with the region of the light transmitting layer 440 in a vertical direction.

The lower surface of the first diffusion layer 430 may be bonded to the upper surface of the resin layer 420. The second diffusion layer 450 may be disposed on the first diffusion layer 430 and may be adhered to the light transmitting layer 440. The light blocking portion 425 may be printed on the lower surface of the second diffusion layer 450, and the second diffusion layer 450 may be fixed on the resin layer 420 through the light transmitting layer 415.

The first and second diffusion layers 430 and 450 may include at least one of a polyester (PET) film, a poly methyl methacrylate (PMMA) material, or a poly carbonate (PC) material. The first and second diffusion layers 430 and 450 may be formed of a resin material film such as silicon or epoxy. Each of the first and second diffusion layers 430 and 450 may include a single layer or multiple layers.

Each of the first and second diffusion layers 430 and 450 may have a thickness of 25 µm or more, for example, in a range of 25 µm to 250 µm or 100 µm to 250 µm. The first and second diffusion layers 430 and 450 may have the thickness range and provide incident light as uniform surface light. At least one or both of the first and second diffusion layers 430 and 450 may include at least one or two or more of a diffusion agent such as a bead, a phosphor, and ink particles. The phosphor may include, for example, at least one of a red phosphor, an amber phosphor, a yellow phosphor, a green phosphor, or a white phosphor. The ink particles may include at least one of metal ink, UV ink, and curing ink. A size of the ink particle may be smaller than a size of the phosphor. The surface color of the ink particle may be any one of green, red, yellow, and blue. The ink types may be selectively applied from among PVC (Poly vinyl chloride) ink, PC (Polycarbonate) ink, ABS (acrylonitrile butadiene styrene copolymer) ink, UV resin ink, epoxy ink, silicone ink, PP (polypropylene) ink, water-based ink, plastic ink, and PMMA (poly methyl methacrylate) ink and PS (Polystyrene) ink. The ink particles may include at least one of metal ink, UV ink, and curing ink. In the lighting device 400, the light diffused by the resin layer 420 sealing the light emitting device package 100 travels upward, and may be emitted as surface light through the first and second diffusion layers 430. In this case, the light blocking portion 425 may prevent hot spots caused by incident light.

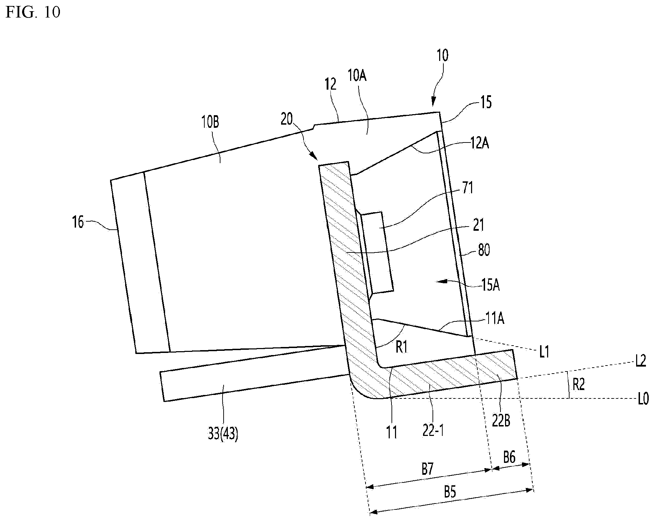

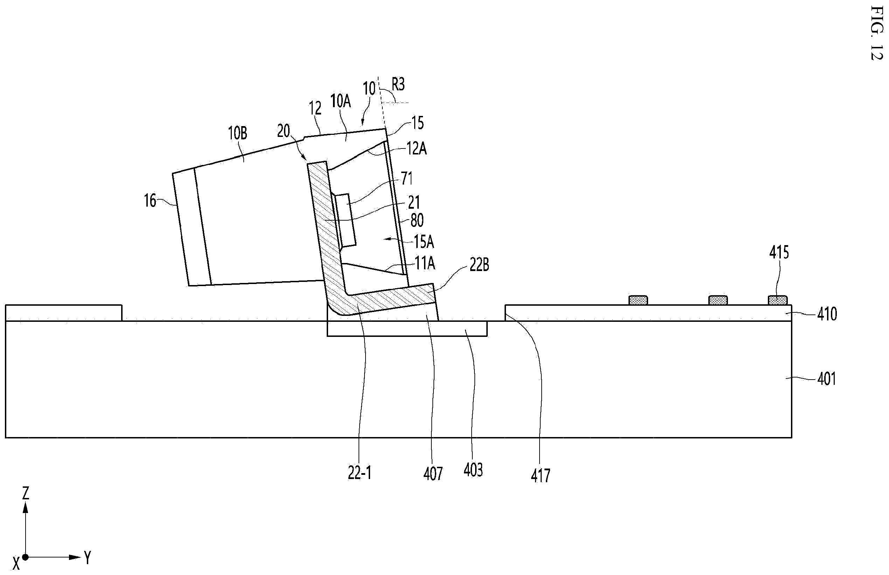

FIGS. 10 to 12 are examples of a light emitting device package and a lighting module having the same according to the second embodiment. The second embodiment will refer to the description of the first embodiment for the same configuration as the first embodiment.

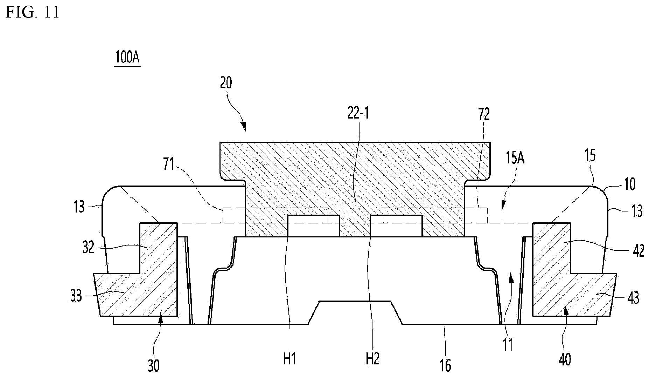

Referring to FIGS. 10 and 11, the light emitting device package 100A may include a body 10 having a cavity 15A, a plurality of lead frames 20, 30, and 40, light emitting chips 71 and 72, and a molding member 80. Among the plurality of lead frames 20, 30, and 40, the second lead frame 20 may have a first bonding portion 22-1 extending toward the front side portion 15 of the body 10. The first bonding portion 22-1 may be bent in all directions of the first side portion 11 of the body 10. The width B5 of the first bonding portion 22-1 may be greater than the width of the first body 10A of the body 10. The width B5 of the first bonding portion 22-1 may be 1.5 times or more, for example, in the range of 1.5 to 2.5 times the depth B7 of the cavity 15A. The width B5 of the first bonding portion 22-1 may be greater than or equal to 7.5 mm, for example, in the range of 7.5 mm to 12 mm. When the width B5 of the first bonding portion 22-1 is provided within the above range, the heat dissipation area is increased, and thermal stress of the light emitting chips 71 and 72 may be suppressed.

The protruding region 22B of the first bonding portion 22-1 may protrude from the front side portion 15 of the body 10 by 3 mm or more, for example, in a range of 3 mm to 5 mm. An end of the protruding heat dissipating portion 22B of the first bonding portion 22-1 may not come into contact with an imaginary straight line L1 passing through the inner surface 11A of the cavity 15A. An angle R1 of the inner surface 11A of the cavity 15A may be disposed within a range of 75 degrees or less, for example, in a range of 65 degrees to 75 degrees with respect to the upper surface of the first frame 21. The first bonding portion 22-1 of the first lead frame 20 is disposed in front of the first side portion 11 of the body 10, and second and third portions are disposed on both rear sides of the first side portion 11. The second and third heat dissipating portions 33 and 43 of the lead frames 20 and 30 may be disposed. Accordingly, the light emitting device package 100A may be bonded on the circuit board 401.

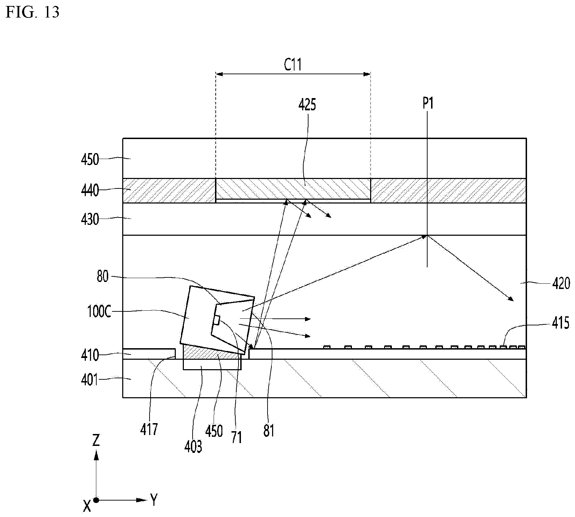

Here, the light emitting device package 100A may be inclined with respect to the horizontal extension line L0 of the horizontal upper surface of the circuit board 401 as the first bonding portion 22-1 protrudes in all directions. That is, the extension line L2 of the lower surface of the first bonding portion 22-1 may be inclined at an angle R2 of 7 degrees or more, for example, in the range of 7 degrees to 12 degrees with respect to the horizontal extension line L0. Accordingly, since the light emitting device package 100A is mounted on the circuit board 401 at the inclined angle R2, the problem of lowering the lower front surface of the light emitting device package 100C as shown in FIG. 13 may be eliminated., the exit surface 81 may be inclined at an angle R3 of more than 90 degrees, for example, 91 degrees to 100 degrees with respect to the extension line L0 perpendicular to the upper surface of the circuit board 401.

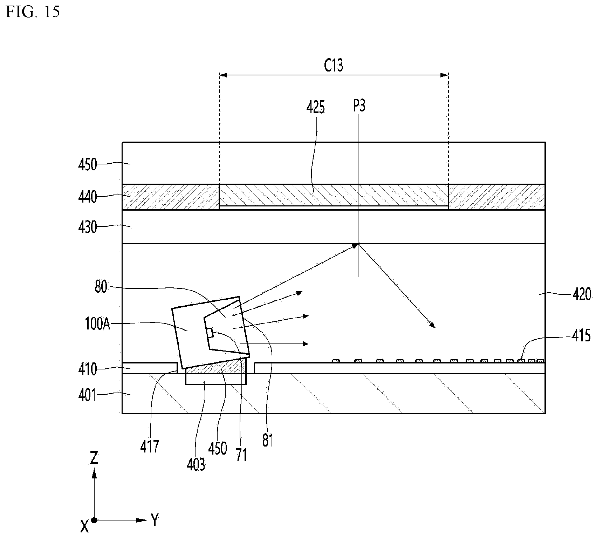

The light emitting device package 100A may have a front top higher than a rear top. As shown in FIG. 15, the light emitted through the exit surface 81 of the light emitting device package 100A may solve the problem of light bouncing at the lower end of the exit side of the light emitting device package 100A, and a hot spot in which light bounces upward or in a vertical direction may be suppressed.

As shown in FIGS. 13 to 15, the front ends of the light emitting device packages 100C, 100B, and 100A are inclined in the direction of the circuit board 401, so that the nearest light directly incident on the first diffusion layer 430 through the exit surface 81 may have a positional relationship: P1>P2>P3. In addition, the length of the light blocking portion 425 may have a relationship of: C11<C12<C13 according to the arrangement of the light emitting device packages 100C, 100B, and 100A. The length C11 may be 9 mm or less, the length C12 may be in the range of 10 mm to 11.5 mm, and the length C13 may be 12 mm or more, for example, in the range of 12 mm to 15 mm. In this case, pitches between adjacent light emitting device packages 100A, 100B, and 100C may be proportionally arranged according to the lengths C11, C12, and C13. The light blocking portion 425 on the light emitting device packages 100A, 100B, and 100C may be formed in a pattern as shown in FIG. 16, and the width C13 and the length C23 of the light blocking portion 425 may vary according to the package mounting type.

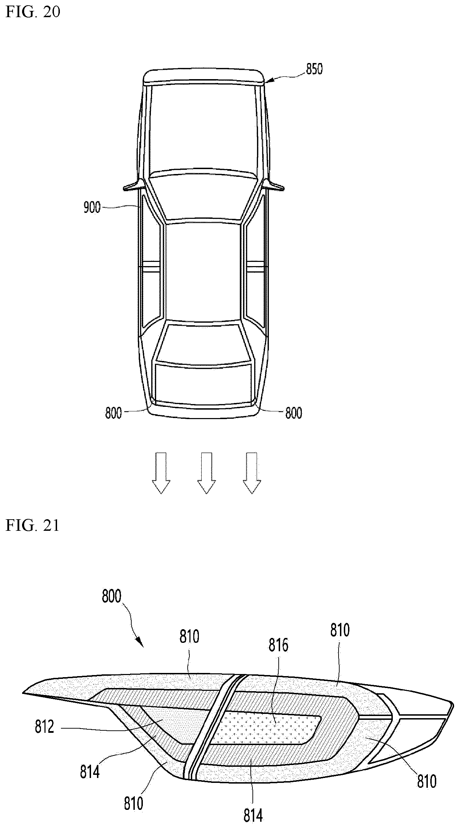

FIG. 20 is a graph comparing luminous flux for each position of the packages of FIGS. 13 to 15 in the lighting device according to an embodiment of the invention. The first region A1 is behind the light emitting device packages 100A, 100B, and 100C, the second region A2 is a region overlapping the light emitting device packages 100A, 100B, and 100C, and the third region A3 is a light blocking region disposed on the front side portion of the light emitting device packages 100A, 100B, and 100C, and a fourth region A4 is a region between the light blocking portions. From these graphs, it may be seen that the hot spot on the second region A2 is suppressed in the lighting device having the light emitting device package 100A of FIG. 15.

As shown in FIG. 17, in the lighting device, a plurality of light emitting device packages 100, 101A, 103, and 103A may be disposed in plurality in first and second directions X and Y. The plurality of light emitting device packages 100, 101A, 103, and 103A are disposed in plurality from the first side surface S1 toward the second side surface S2 of the circuit board 401, or in plurality between the third and fourth side surfaces S3 and S4. The light emitting device packages 100, 101A, 103, and 103A may be arranged in a matrix form, zigzag form, or may be arranged to be distributed in different regions.

FIG. 21 is a plan view of a vehicle to which a vehicle lamp to which a lighting device according to an embodiment is applied, and FIG. 22 is a view illustrating a lighting device disclosed in the embodiment or a vehicle lamp having a lighting device.

Referring to FIGS. 21 and 22, in a mobile body or vehicle 900, a front lamp 850 may include one or more lighting modules, and individually control driving timings of these lighting modules to function as normal headlights as well as, When the driver opens the vehicle door, additional functions such as a welcome light or a celebration effect can be provided. The lamps may be applied to daytime running lights, high beams, low beams, fog lights or direction indicators.

In the vehicle 900, the taillight 800 may include a plurality of lamp units 810, 812, 814, and 816 supported by the housing 801. For example, the lamp units 810, 812, 814, and 816 may include a first lamp unit 810 disposed outside, a second lamp unit 814 disposed around the inside of the first lamp unit 810, and third and fourth lamp units 814 and 816 respectively disposed inside of the second lamp unit 814. The first to fourth lamp units 810, 812, 814, and 816 may selectively apply the lighting device disclosed in the embodiment, and a red lens cover or a white lens cover for lighting characteristics of the lamp units 810, 812, 814, and 816 may be disposed outside the lighting device. The lighting device disclosed in the embodiment applied to the lamp units 810, 812, 814, and 816 may emit surface light with a uniform distribution.

The first and second lamp units 810 and 812 may be provided in at least one of a curved shape, a straight shape, an angled shape, an inclined shape, and a flat shape, or a mixed structure thereof. One or a plurality of the first and second lamp units 810 and 812 may be disposed in each taillight. The first lamp unit 810 may be provided as a tail light, the second lamp unit 812 may be provided as a brake light, and the third lamp unit 814 may be provided as a reversing light. The fourth lamp unit 816 may serve as a turn signal lamp. The structure and location of these lighting lamps may be changed. Features, structures, effects, etc. described in the embodiments above are included in at least one embodiment of the present invention, and are not necessarily limited to only one embodiment. Furthermore, the features, structures, effects, etc. illustrated in each embodiment can be combined or modified with respect to other embodiments by those skilled in the art in the field to which the embodiments belong. Therefore, contents related to these combinations and variations should be construed as being included in the scope of the present invention. In addition, although described based on the embodiments above, this is only an example, not limiting this invention, it will be apparent to those skilled in the art that various modifications and applications not illustrated above can be made without departing from the essential characteristics of this embodiment. For example, each component specifically shown in the embodiment can be modified and implemented. And the differences related to these modifications and applications should be construed as being included in the scope of the present invention as defined in the appended claims.

## Claims

1. A lighting device comprising:
a light emitting device package including a plurality of lead frames, a body coupled to the plurality of lead frames, a cavity in which a front side portion of the body is opened, and a light emitting chip disposed on a first lead frame that is any one of the plurality of lead frames;
a circuit board on which the light emitting device package is disposed and having a first pad portion;
a resin layer covering the light emitting device package on the circuit board;
a reflective member disposed between the resin layer and the circuit board and into which a lower portion of the light emitting device package is inserted; and
a light blocking portion overlapping the light emitting device package in a vertical direction on the resin layer,
wherein the first lead frame includes a first frame disposed at a bottom of the cavity and is bent from the first frame to a lower surface of the body, and a first bonding portion coupled to the first pad portion of the circuit board, and
wherein the first bonding portion protrudes from the lower surface of the body toward a rear side portion of the body more than the rear side portion of the body.

2. A lighting device comprising:
a light emitting device package including a plurality of lead frames, a body coupled to the plurality of lead frames, a cavity in which a front side portion of the body is opened, and a light emitting chip disposed on a first lead frame that is any one of the plurality of lead frames;
a circuit board on which the light emitting device package is disposed and having a first pad portion;
a resin layer covering the light emitting device package on the circuit board;
a reflective member disposed between the resin layer and the circuit board and into which a lower portion of the light emitting device package is inserted; and
a light blocking portion overlapping the light emitting device package in a vertical direction on the resin layer,
wherein the first lead frame includes a first frame disposed at a bottom of the cavity and is bent from the first frame to a lower surface of the body, and a first bonding portion coupled to the first pad portion of the circuit board, and
wherein the first bonding portion protrudes from the lower surface of the body toward a front side portion of the body more than the front side portion of the body.

3. The lighting device of claim 1, wherein the plurality of lead frames includes second and third lead frames disposed on both sides of the first lead frame, and
wherein the light emitting chip is disposed on a first frame of the first lead frame in plurality.

4. The lighting device of claim 1, wherein the first bonding portion has a width from the bottom of the cavity toward the rear side portion greater than a length, and
wherein a length direction of the first bonding portion is perpendicular to a width direction and is a direction from a third side portion toward a fourth side portion of the body.

5. The lighting device of claim 4, wherein a ratio of the length to the width of the first bonding portion is in a range of 1:6 to 1:8.

6. The lighting device of claim 2, wherein the first bonding portion has a length from the bottom of the cavity toward the front side portion greater than a depth of the cavity, and
wherein an end of the first bonding portion is not in contact with an imaginary straight line passing through an inner surface of the cavity adjacent to the first bonding portion.

7. The lighting device of claim 6, wherein a horizontal imaginary straight line passing through the first bonding portion of the light emitting device package is inclined at an angle of 7 degrees to 12 degrees with respect to an upper surface of the circuit board.

8. The lighting device of claim 7, wherein an imaginary straight line passing through an exit surface of the cavity disposed on the front side portion of the light emitting device package is inclined at an angle of 91 degrees to 100 degrees with respect to the upper surface of the circuit board.

9. The lighting device of any one of claims 1 to 8, comprising:
at least one diffusion layer on the resin layer; and
a light transmitting layer of an adhesive material is provided on a lower surface of the at least one diffusion layer,
wherein the light blocking portion is disposed on the lower surface of the at least one diffusion layer.

10. The lighting device of any one of claims 1 to 8,
wherein the light blocking portion includes a plurality of pattern layers having different sizes,
wherein an uppermost layer in the plurality of pattern layers has a largest area and a lowermost layer has a smallest area.

11. The lighting device of any one of claims 1 to 8,
wherein the reflective member includes an opening through which the first pad portion to which the first bonding portion of the light emitting device package is bonded is exposed, and
wherein the reflective member includes a reflective pattern on a surface thereof.
